# FASCICULE DE BREVET EUROPEEN

(11) **EP 1 128 589 B1**
(45) Date de publication et mention de la délivrance du brevet: **20.07.2005**
(21) Numéro de dépôt: 01400388.3
(22) Date de dépôt: 14.02.2001
(51) Int. Cl.: H04L 1/00, H03M 13/29, H03M 13/45, H03M 13/41

(54) **Critère d'interruption pour un décodeur turbo**
Abbruchkriterium für einen Turbodekoder
Interruption criterion for a turbo decoder

(30) Priorité: 14.02.2000 FR 0001984
(43) Date de publication de la demande: 29.08.2001
(73) Titulaire: Mitsubishi Electric Information Technology Centre Europe B.V., 1119 NS Schiphol Rijk (NL)
(72) Inventeur: Gueguen, Arnaud, 35700 Rennes (FR)
(74) Mandataire: Maillet, Alain

(56) Documents cités:
- US-A- 5 446 747
- US-A- 5 761 248
- US-A- 5 983 385

## Description

La présente invention concerne de manière générale un procédé de transmission numérique de type à codage correcteur d'erreurs, notamment pour un système de transmission numérique sur canal à perturbation importante. Plus précisément, elle concerne l'interruption du décodage itératif d'un procédé de transmission numérique de type à codage correcteur d'erreurs utilisant des schémas de codage de type turbo-code.

Un système de transmission numérique véhicule de l'information en utilisant un support physique comme le câble, la fibre optique ou la propagation sur un canal radioélectrique satellitaire ou non. On désignera un tel support physique par le terme canal. Généralement, un tel système comprend notamment, au niveau de l'émission, un dispositif appelé codeur de canal et, au niveau de la réception, un dispositif décodeur correspondant.

Le dispositif codeur de canal a une fonction dite de codage correcteur d'erreurs. La fonction de codage correcteur d'erreurs consiste à générer une information redondante à l'émission, qui, lors du décodage au niveau de la destination, va permettre de reconstituer l'information utile transmise, à partir de l'information arrivant à destination, appelée information reçue, entachée par les perturbations intervenant sur le canal, notamment de type bruit, atténuations et interférences. Un procédé de transmission numérique utilisant un tel codage canal associé à un décodage correspondant de destination est appelé procédé de transmission de type à codage correcteur d'erreurs.

Par exemple, l'opération de codage se fait au niveau du bit. Cette opération associe à une séquence binaire d'information utile une séquence binaire d'information codée correspondante. On appelle mot de code cette séquence binaire d'information codée lorsque la taille des séquences binaires d'information utile est fixe. La séquence binaire d'information codée est de taille supérieure à la séquence binaire d'information utile de manière à introduire une redondance. Du fait de cette redondance, seules certaines séquences d'information codée, conformes à la loi de codage, sont possibles. Si des séquences d'information reçue à décoder sont différentes de ces séquences possibles, c'est qu'elles correspondent à de l'information détériorée par le canal. Le rôle du procédé de décodage va donc être de reconstituer au mieux l'information utile à partir de la séquence d'information reçue, en connaissant la loi de codage utilisée. On sait décoder les codes les plus simples de façon optimale, c'est-à-dire en retrouvant parmi toutes les séquences possibles la séquence la plus vraisemblable. Pour les codes les plus complexes comme les turbo-codes, le facteur limitant est, en général, la complexité du décodeur.

La performance d'une transmission à codage correcteur d'erreurs se mesure généralement en terme de taux d'erreurs binaires ou paquets pour un rapport signal sur bruit E_{b}/Nₒ donné, où E_{b} est l'énergie par bit d'information et Nₒ est la densité spectrale de puissance du bruit. On qualifie de plus ou moins performant un code selon que son emploi permet un taux d'erreurs plus ou moins faible pour un rapport E_{b}/Nₒ donné et pour une complexité de décodage donnée.

Le rendement du code est le nombre de bits d'information utile par bit d'information codée.

Des codes correcteurs d'erreurs connus sont les codes en bloc. Le codage en bloc consiste à associer à chaque bloc de k bits d'information un bloc de n bits (n>k) contenant donc (n-k) bits de redondance. Le bloc de n bits est obtenu en multipliant le bloc de k bits utile par une matrice à k lignes et n colonnes appelée matrice génératrice du code. Lorsque, par permutation, la matrice génératrice est écrite sous une forme telle qu'elle fait apparaître la matrice identité, de sorte que, dans le bloc de n bits, les k bits d'information et les n-k bits de redondance sont séparés, le code est dit systématique. Le rendement du code est égal à k/n. Le dispositif décodeur détecte les erreurs et les corrige par l'intermédiaire de la distance de Hamming minimale. De tels codes correcteurs d'erreurs bien connus dans la technique sont par exemple les codes de Hamming, les codes BCH et les codes de Reed-Solomon.

Est également bien connu le fait d'effectuer un codage correcteur d'erreurs à l'aide d'un ou plusieurs codeurs convolutifs. Leur principe de fonctionnement consiste à coder un bloc de k éléments binaires présents à l'entrée du codeur en un bloc de n éléments binaires en tenant compte également de m blocs précédents le bloc présent en entrée, à l'aide d'un dispositif à registre de type registre à décalage. La sortie du codeur convolutif est constituée de n éléments binaires codés générés par le produit de convolution des k éléments binaires présents à l'entrée avec la réponse du codeur définie par n polynômes générateurs. Le rendement du code est égal à k/n. Le dispositif décodeur reconstruit les données d'origine par exemple à l'aide d'un décodage de type séquentiel, un décodage suivant le symbole le plus vraisemblable, ou un décodage suivant la séquence la plus vraisemblable, ainsi que décrit, par exemple, dans le document « Digital Communications », par J.G. Proakis, paru en 1995 aux éditions MacGraw-Hill. Par exemple, l'algorithme de Viterbi assure un décodage optimal suivant la séquence la plus vraisemblable.

Selon une variante de ce type de codes, le codage ne se fait pas en prenant directement en compte une série de m informations utiles précédant l'information à coder, mais en utilisant une série de m informations auxiliaires, mémorisées dans un dispositif de type registre à décalage obtenues chacune par combinaison mathématique d'une information utile et de m informations auxiliaires calculées précédemment. Un tel code convolutif est dit récursif. Lorsque, en outre, l'information utile ressort telle quelle parmi les n sorties du codeur au côté de (n-1) informations codées ou informations redondantes, le code résultant est appelé code convolutif récursif systématique, ou code RSC.

Est également connu le fait d'associer différents codeurs afin d'augmenter la performance du codage. Par exemple, les données codées par un premier codeur peuvent alimenter un second codeur. Le décodage se fait symétriquement, en commençant par le second code.

Un type performant d'association de codeurs a été proposé, ainsi que décrit notamment dans le document « Near Shannon Limit Error - Correcting Coding and Decoding : Turbo-codes », par C. Berrou, A. Glavieux, P. Thitimajshima, paru dans ICC-1993, Conference Proceedings aux pages 1064-1070. Ce type d'association de codeurs a donné naissance a une famille de schémas de codage connue dans la technique sous le nom de turbo-codes. L'on désignera par turbo-codes les codes correcteurs d'erreurs basés sur l'association, appelée concaténation, de plusieurs codes simples, appelés codes élémentaires, avec intervention d'opérations de permutation, appelées entrelacements, qui modifient l'ordre de prise en compte des données par chacun des codes simples. Par exemple, un type d'entrelacement classique, dit entrelacement uniforme, est obtenu à l'aide d'une matrice d'entrelacement dans laquelle les données source sont introduites ligne par ligne et restituées colonne par colonne. En général, pour améliorer les performances, les turbo-codes utilisent des entrelacements non-uniformes. Par codes élémentaires, on entend des codes de rendement supérieur ou égal à 1, du type décrit plus haut. Il peut s'agir, par exemple, de codes convolutifs récursifs systématiques pour les turbo-codes convolutifs, des codes en bloc de Hamming ou BCH pour les turbo-codes en bloc. Différents types de concaténation peuvent être envisagés. Dans la concaténation parallèle, la même information est codée par chaque codeur séparément après avoir été entrelacée. Dans la concaténation série, la sortie de chaque codeur est codée par le codeur suivant après avoir été entrelacée. On appelle dimension du turbo-code le nombre de codeurs élémentaires utilisés pour mettre en oeuvre ce turbo-code. Un schéma de turbo-codage bien connu consiste en une concaténation parallèle de codes élémentaires de type Codes Convolutifs Récursifs Systématiques (RSC). On désigne ce turbo-code par le terme PCCC. Des exemples de turbo-codes à concaténation série sont les SCCC qui utilisent des codes élémentaires de type codes convolutifs et les turbo-codes en bloc qui utilisent des codes élémentaires de type codes en bloc.

Une information codée par un turbo-code peut être décodée par un procédé itératif appelé turbo-décodage. Un exemple de turbo-décodage est donné dans le document précité « Near Shannon Limit Error - Correcting Coding and Decoding : Turbo-codes », par C. Berrou, A. Glavieux, P. Thitimajshima, paru dans ICC-1993, Conference Proceedings aux pages 1064-1070. Dans cet exemple, il s'agit du turbo-décodage d'un turbo-code à concaténation parallèle. Sont associés plusieurs décodeurs élémentaires à entrées et sorties pondérées correspondant chacun à un codeur élémentaire du dispositif de codage. Les entrées et sorties pondérées se font en termes de probabilités, de rapports de vraisemblance, ou de logarithmes de rapports de vraisemblance. Les entrées et sorties pondérées sont en général associées à chacun des symboles m-aires en entrée et en sortie des codeurs élémentaires, c'est-à-dire, par exemple, à des bits si des codeurs binaires sont utilisés comme codeurs élémentaires. Les décodeurs interviennent l'un après l'autre dans le cas d'un type de turbo-décodage appelé turbo-décodage série, ou simultanément dans un type de turbo-décodage dit turbo-décodage parallèle. Des schémas de concaténation intermédiaires peuvent également être envisagés. Des entrelaceurs et désentrelaceurs interviennent en fonction des entrelacements réalisés au niveau du codage. Ils permettent à chaque décodeur de prendre en compte une information qui se présente dans le même ordre que celle en sortie et en entrée du codeur correspondant. Chaque décodeur élémentaire utilise l'information disponible qui correspond à l'information en entrée et en sortie du codeur élémentaire correspondant. L'information disponible utilisée par le décodeur élémentaire, dite information a priori, est constituée d'une sortie de l'étape précédant le décodage de canal, à savoir, en général, une étape de démodulation, , et d'une information générée par une ou plusieurs étapes de décodage élémentaire précédentes. Grâce à cette information a priori et connaissant la loi de codage du codeur élémentaire correspondant, le décodeur élémentaire génère une information a posteriori qui est une estimation de plus grande fiabilité de l'information en entrée. Le supplément d'information par rapport à l'information en entrée est appelé information extrinsèque. Cette information extrinsèque est transmise au décodeur élémentaire suivant qui va l'utiliser comme information a priori après entrelacement ou désentrelacement, et combinaison éventuelle. Chaque étape de décodage élémentaire bénéficie donc en entrée d'une information a priori dont la qualité est accrue par les décodages élémentaires effectués lors des étapes de décodage élémentaire précédentes. Cette information extrinsèque dépend de l'information redondante introduite par le codeur correspondant. Le procédé est itératif en ce que l'information extrinsèque calculée par le ou les derniers décodeurs de la série est rétropropagée vers le ou les premiers décodeurs de la série. L'échange d'information extrinsèque se fait entre décodeurs élémentaires au sein d'une même étape, et de cette étape vers l'étape suivante. Chaque nouvelle étape accroît donc la fiabilité de l'information générée en sortie. Après un certain nombre d'itérations, le procédé de décodage stagne, qu'il ait convergé vers la solution ou non. Un seuillage est appliqué pour générer l'information décodée.

Bien entendu, l'appellation turbo-décodage englobe divers schémas de concaténation envisageables, dépendant par exemple du type de turbo-codage mis en oeuvre. Par exemple, dans le turbo-décodage correspondant à un turbo-code à concaténation série, les décodeurs élémentaires étant associés dans l'ordre inverse des codeurs élémentaires, chaque décodeur élémentaire reçoit deux informations pondérées a priori correspondant l'une à l'information de sortie du codeur élémentaire correspondant et l'autre à l'information d'entrée du codeur élémentaire correspondant. Ce décodeur élémentaire produit deux informations pondérées a posteriori, l'une correspondant à la sortie du codeur élémentaire correspondant, et qui devient donc, lors d'une itération suivante, après entrelacement correspondant, entrée a priori d'un décodeur élémentaire précédent, et l'autre correspondant à l'entrée du codeur élémentaire correspondant, et qui devient donc, dans la même itération, après désentrelacement correspondant, entrée a priori d'un décodeur élémentaire suivant.

Quoiqu'il en soit, l'on peut toujours définir l'information extrinsèque comme le supplément d'information apporté par un décodage élémentaire associé à un codage élémentaire par rapport à une information a priori, intervenant en entrée du décodage élémentaire.

En outre, l'on peut utiliser divers types d'algorithmes pour décodeurs élémentaires à entrées et sorties pondérées. Les décodeurs élémentaires utilisent par exemple les algorithmes MAP, LogMAP et MaxLogMAP, encore appelés APP, LogAPP et MaxLogAPP, qui dérivent tous du calcul de probabilités a posteriori connaissant des probabilités a priori. L'on peut se référer, pour une description de tels algorithmes de décodage, par exemple à l'article « Optimal and sub-optimal maximum a posteriori algorithms suitable for turbo decoding » de P. Robertson, P. Hoeher, E. Villebrun, paru dans European Trans. on Telecommun., vol. 8, mars-avril 1997, aux pages 119-125. L'on peut également utiliser des algorithmes du type algorithmes de Viterbi modifiés pour associer à chaque décision une mesure de fiabilité de type comparable au LRV (logarithme de rapport de vraisemblance). L'on peut par exemple utiliser l'algorithme SOVA (Soft Output Viterbi Algorithm). Pour les turbo-codes en bloc, l'on peut utiliser un algorithme de Chase, ainsi que décrit dans l'article « A very low complexity block turbo decoder for product codes » par R. Pyndiah, P. Combelles et P. Adde, paru dans IEEE Globecom de 1996, aux pages 101 à 105.

Est également connu le fait que le rendement d'un code peut être augmenté par une opération de poinçonnage qui consiste à ne pas transmettre certains bits d'une séquence d'information, ainsi qu'il est décrit, par exemple, dans l'article « Rate-Compatible Punctured Convolutional (RCPC) codes and their application », par J. Hagenauer, paru dans IEEE Trans., Vol COM-36.4, 1988, aux pages 389-400 ou dans l'article «New Rate Compatible Punctured Convolutional Codes for Viterbi decoding », par L.H.C. Lee, paru dans IEEE Trans., Vol. COM-42.2, 1994, aux pages 3073-3079. Ces bits non transmis sont en général des bits d'information redondante. Cette opération de poinçonnage intervient au niveau de l'émission, après l'opération de codage. Au niveau de la destination, une opération réciproque de dépoinçonnage est effectuée avant l'opération de décodage. Les opérations de poinçonnage et de dépoinçonnage sont définies par une matrice ou schéma de poinçonnage. Le poinçonnage de bits d'information redondante diminue la capacité de correction du code et augmente son rendement.

Les codes correcteurs d'erreurs de la famille des turbo-codes selon l'état de la technique décrit plus haut permettent d'obtenir une correction d'erreurs très performante tout en conservant des rendements suffisamment importants et en permettant des opérations de décodage à faible complexité au regard de la complexité du code. Le turbo-décodage, sous-optimal dans son principe, présente des performances proches de celles du décodeur optimal et une complexité nettement moindre, puisqu'elle est de l'ordre de celle du décodage des codes élémentaires.

Cependant, la complexité du turbo-décodage ainsi que des paramètres comme le délai de turbo-décodage ou la consommation d'énergie pour le turbo-décodage peuvent augmenter avec le nombre d'itérations de la procédure de turbo décodage. Se pose alors le problème de l'interruption du turbo-décodage. Bien entendu, peut être fixé un nombre prédéterminé d'itérations de turbo-décodage. Mais il se peut alors que ce nombre d'itérations prédéterminé soit ou bien insuffisant, ne permettant alors pas d'atteindre une correction d'erreurs satisfaisante, ou bien trop important, faisant qu'un certain nombre d'itérations sont inutiles. Cette manière de procéder se fait donc soit au détriment de la performance de la transmission, mesurée par exemple en terme de taux d'erreurs binaires, soit au détriment de conditions de transmission comme la complexité du turbo-décodage, le délai de turbo-décodage ou la consommation d'énergie pour le turbo-décodage.

Généralement, on fixe un nombre maximal d'itérations correspondant à une complexité et/ou un délai de décodage maximal tolérés, et on utilise un critère d'arrêt pour interrompre le processus de décodage si celui-ci semble avoir donné lieu à une convergence vers l'information utile avant le nombre maximal d'itérations. La détection de convergence peut être effectuée de différentes façons. Par exemple, un code détecteur d'erreurs de type CRC (Cyclic Redundancy Check) peut être utilisé. Si, au cours du turbo-décodage d'une séquence d'informations, le calcul du code détecteur d'erreurs indique qu'il n'y a plus d'erreurs, on interrompt le décodage itératif pour cette séquence. Un inconvénient de ce procédé découle du fait qu'un code détecteur d'erreurs doit être introduit à l'émission, ce qui fait baisser le rendement global du codeur de canal.

Ont été également proposés des critères d'interruption du turbo-décodage basés sur la comparaison de séquences d'informations en sortie d'au moins deux décodeurs élémentaires successifs. De tels critères d'interruption sont décrits, par exemple, dans le brevet US-A-5 761 248, dans un article de M. Moher dont le titre est « Decoding via Cross-Entropy Minimization », paru dans « proceedings of Globecom'93, IEEE Global Telecommunications Conference », vol.2, pages 809-813, ou dans un article de R.Y. Shao, S. Lin, M.P.C. Fossorier dont le titre est « Two simple stopping criteria for turbo-décoding », paru dans « IEEE Transactions on Comm. », vol 47, n°8, août 1999, pages 1117-1120. L'utilisation de tels critères d'interruption du turbo-décodage se fonde notamment sur le fait qu'une stagnation des sorties des décodeurs élémentaires au cours du décodage itératif d'une séquence d'informations indique que des itérations de décodage supplémentaires ne réduiront pas davantage le nombre d'erreurs intervenant sur cette séquence d'informations.

Néanmoins, ce type de critère d'interruption de turbo-décodage pose deux types de problèmes.

Tout d'abord, si le principe sur lequel ce critère se fonde permet de manière relativement simple de commander l'arrêt du traitement de décodage, il ne donne pas d'indication sur la qualité des séquences d'informations décodées, c'est-à-dire sur le nombre d'erreurs qu'elles contiennent encore par rapport à l'information utile ni même sur la présence éventuelle d'erreurs résiduelles.

Ensuite, la mise en oeuvre de ce type de critère d'interruption suppose le stockage d'une séquence d'informations issue d'une étape qui précède l'étape de décodage considérée afin de procéder à la comparaison. Généralement, il faut même stocker plusieurs séquences issues d'étapes précédant l'étape considérée afin que le fonctionnement du critère soit satisfaisant.

Enfin, ce critère d'interruption étant basé sur une stagnation des sorties de décodeurs élémentaires successifs, il détecte la convergence du procédé de décodage au moins une étape après qu'il a effectivement convergé. Dans le cas d'une convergence à l'avant-dernière étape de décodage élémentaire, la dernière étape effectuée est donc inutile.

Un objet de la présente invention est donc d'améliorer l'interruption du décodage itératif d'un procédé de transmission numérique de type à codage correcteur d'erreurs utilisant des schémas de codage de type turbo-code. Pour cela, a été recherché un critère d'interruption du turbo-décodage permettant de résoudre les problèmes évoqués ci-dessus.

A cet effet, elle propose un procédé de transmission numérique de type à codage correcteur d'erreurs, comprenant, avant une étape de transmission sur un canal, une procédure de codage pour générer, à partir d'une information utile, une information codée comprenant au moins une information redondante et, après ladite étape de transmission sur ledit canal, une procédure de décodage pour obtenir, à partir d'une information reçue à décoder, une estimation de ladite information utile avec correction des erreurs de transmission basée sur ladite au moins une information redondante, ladite procédure de codage comprenant une pluralité d'étapes de codage élémentaire associée à au moins une étape d'entrelacement et opérant en parallèle ou en série, ladite procédure de décodage étant itérative et comprenant, pour chaque itération, une pluralité d'étapes de décodage élémentaire associée à des étapes d'entrelacement et de désentrelacement, correspondant à ladite pluralité d'étapes de codage élémentaire associée à ladite au moins une étape d'entrelacement, chacune desdites étapes de décodage élémentaire recevant un ensemble d'informations à décoder et générant un ensemble d'informations de sorties pondérées associé à un ensemble d'informations décodées, ledit procédé étant caractérisé en ce qu'il comprend une étape de détermination de grandeur caractéristique adaptée à calculer, pour chacune desdites étapes de décodage élémentaire, une grandeur caractéristique d'un ensemble d'informations extrinsèques associé seulement audit ensemble d'informations de sorties pondérées en sortie de cette étape de décodage élémentaire, une étape de comparaison adaptée à comparer ladite grandeur caractéristique à une grandeur de seuil, et une étape d'interruption pour interrompre ladite procédure de décodage lorsque ladite grandeur caractéristique atteint ladite grandeur de seuil.

Avantageusement, ladite étape de détermination de grandeur caractéristique est adaptée à calculer, pour chacune desdites étapes de décodage élémentaire, une grandeur caractéristique d'un ensemble d'informations extrinsèques correspondant audit ensemble d'informations de sorties pondérées associé à un ensemble d'informations décodées.

Il est en effet avantageux de calculer cette grandeur caractéristique à partir de l'information extrinsèque qui permet de donner de manière simple une indication du nombre d'erreurs restant dans une séquence de décodage.

On comprendra que l'on peut néanmoins calculer une grandeur caractéristique directement à partir des sorties pondérées dans lesquelles, au bout d'un certain nombre d'itérations, l'information extrinsèque devient essentielle.

L'on a déterminé qu'il existe une corrélation entre, d'une part, la moyenne de la valeur absolue de l'information extrinsèque calculée sur une séquence de N valeurs extrinsèques en sortie d'un décodeur donné lors d'une itération donnée et, d'autre part, le nombre d'erreurs restant dans la séquence de N bits décodée en sortie de ce décodeur donné pour cette itération donnée. On constate que cette moyenne croît rapidement dès que le décodage de la séquence converge alors qu'elle stagne tant que ce décodage ne converge pas. Ainsi, lorsque cette moyenne atteint une grandeur de seuil suffisante, il existe une forte probabilité que la séquence ne contienne plus d'erreur. Il devient donc inutile de poursuivre le décodage pour cette séquence.

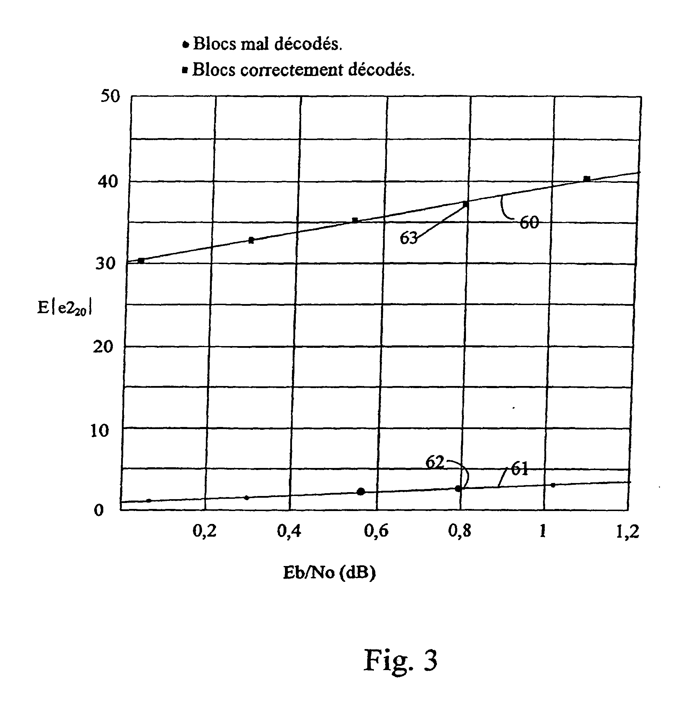

On a pu établir des courbes, comme celle représentée sur la Fig. 3, montrant, pour différentes conditions de transmission, exprimées par exemple en terme de rapport signal sur bruit, la différence entre la moyenne de la valeur absolue de l'information extrinsèque pour des séquences mal décodées et des séquences correctement décodées.

Ainsi, avantageusement, la grandeur caractéristique calculée par ladite étape de détermination de grandeur caractéristique sera la moyenne de la valeur absolue de l'information extrinsèque calculée sur l'ensemble d'informations extrinsèques considéré. Dans ce cas, l'étape d'interruption interrompra la procédure de décodage lorsque la moyenne de la valeur absolue de l'information extrinsèque calculée par l'étape de détermination de grandeur caractéristique sera supérieure à une grandeur de seuil adaptée.

Cependant, cette grandeur caractéristique pourra également être une autre grandeur statistique caractéristique de cet ensemble d'informations extrinsèques, comme sa variance, son minimum ou son maximum. Peut être également utilisée la somme des valeurs absolues des informations extrinsèques de cet ensemble d'informations extrinsèques.

Ainsi définie, la présente invention s'applique à tous types de procédé de transmission utilisant un codage correcteur d'erreurs de type à turbo-codage et turbo-décodage, qu'il s'agisse d'un turbo-codage à concaténation série ou parallèle, d'un turbo-décodage à concaténation série ou parallèle ou de schémas de concaténation mixte.

Selon un autre aspect de la présente invention, le procédé de transmission numérique comprend également une étape de détermination de grandeur de seuil pour déterminer une grandeur de seuil en fonction d'au moins un paramètre de configuration.

Un paramètre de configuration peut être un paramètre caractérisant les conditions de transmission comme, par exemple, le rapport signal sur bruit. Il peut également s'agir d'un paramètre caractérisant, par exemple, un algorithme de décodage élémentaire, la taille du bloc d'information utile, un type de grandeurs utilisées, un nombre maximal d'itérations, un type de canal de transmission, etc. Bien entendu, en général, l'étape de détermination de grandeur de seuil déterminera une grandeur de seuil en fonction d'une pluralité de paramètres de configuration.

Cette étape de détermination de grandeur de seuil peut employer un algorithme adaptatif permettant le calcul d'une grandeur de seuil en fonction d'un ou plusieurs paramètres de configuration.

Cette étape de détermination de grandeur de seuil peut également employer des tables de référence préétablies permettant de sélectionner une grandeur de seuil en fonction d'un ou plusieurs paramètres de configuration.

Selon un autre aspect de la présente invention, ladite étape de détermination de grandeur de seuil détermine une grandeur de seuil de manière à réaliser un compromis entre la performance permise par ladite procédure de décodage et la complexité de cette procédure de décodage.

Par exemple, dans le cas où la grandeur caractéristique choisie est la moyenne de la valeur absolue de l'information extrinsèque, la grandeur de seuil sera choisie, d'une part, suffisamment importante pour assurer que le nombre d'erreurs restant dans une séquence décodée soit suffisamment faible et, d'autre part, suffisamment faible pour limiter le nombre d'itérations nécessaires pour atteindre cette valeur de seuil.

De manière similaire, ladite étape de détermination de grandeur de seuil détermine une grandeur de seuil de manière à assurer une certaine qualité de transmission.

Par exemple, ladite étape de détermination de grandeur de seuil détermine une grandeur de seuil en fonction d'un délai moyen de transmission souhaité.

Ladite étape de détermination de grandeur de seuil peut également déterminer une grandeur de seuil en fonction d'une consommation d'énergie moyenne tolérée.

Selon un autre aspect de la présente invention, un nombre maximal tolérable d'itérations ayant été prédéfini, ladite étape de détermination de grandeur de seuil détermine une grandeur de seuil en combinant, d'une part, une première grandeur caractéristique d'un premier ensemble d'informations extrinsèques généré par un dernier décodeur élémentaire lors d'une dernière itération et associé à un premier ensemble d'informations décodées correspondant au décodage sans erreur d'un ensemble d'informations à décoder, et, d'autre part, une seconde grandeur caractéristique d'un second ensemble d'informations extrinsèques généré par ledit dernier décodeur lors de ladite dernière itération et associé à un second ensemble d'informations décodées correspondant au décodage dudit ensemble d'informations à décoder dans le cas où il reste des erreurs.

Avantageusement, lesdites première et seconde grandeurs seront les moyennes de la valeur absolue de l'information extrinsèque calculées sur, respectivement, ledit premier ensemble d'informations extrinsèques et ledit second ensemble d'informations extrinsèques.

Cependant, cette première et cette seconde grandeurs pourront également être toutes autres grandeurs statistiques caractéristiques de, respectivement, ce premier et ce second ensembles d'informations extrinsèques, comme leurs variances, leurs minima ou leurs maxima. Peuvent être également utilisées les sommes des valeurs absolues des informations extrinsèques de, respectivement, ce premier et ce second ensembles d'informations extrinsèques.

Lesdites première et seconde grandeurs peuvent être déterminées, en fonction d'au moins un paramètre de configuration, à l'aide d'un algorithme adaptatif ou d'une table de référence préétablie. En pratique, la détermination de ces première et seconde grandeurs se fera en fonction d'une pluralité de paramètres de configuration.

Ladite grandeur de seuil pourra notamment être la somme de ladite première grandeur multipliée par un coefficient α et de ladite seconde grandeur multipliée par un coefficient (1-α), le coefficient α étant choisi entre 0 et 1.

Avantageusement, ce coefficient α sera choisi de manière à réaliser un compromis entre la performance permise par ladite procédure de décodage et la complexité de cette procédure de décodage.

Par exemple, dans le cas où la grandeur caractéristique choisie est la moyenne de la valeur absolue de l'information extrinsèque, le coefficient α sera choisi, d'une part, suffisamment important pour assurer que le nombre d'erreurs restant dans une séquence décodée soit suffisamment faible et, d'autre part, suffisamment faible pour limiter le nombre d'itérations réalisées par la procédure de décodage.

De manière similaire, le coefficient α sera choisi de manière à assurer une certaine qualité de transmission.

Par exemple, le coefficient α sera choisi en fonction d'un délai moyen de transmission souhaité.

Ledit coefficient α peut également être choisi en fonction d'une consommation d'énergie moyenne tolérée.

Avantageusement, le coefficient α est déterminé à l'aide d'un algorithme adaptatif ou d'une table de référence préétablie.

Selon un autre aspect de la présente invention, lesdites étapes de décodage élémentaire sont à entrées et sorties pondérées, en termes de probabilités, de rapports de vraisemblance, ou de logarithmes de rapports de vraisemblance.

Selon un autre aspect de la présente invention, ladite procédure de codage comprend au moins une étape de poinçonnage et ladite procédure de décodage comprend au moins une étape de dépoinçonnage correspondante.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
la Fig. 1 est un schéma illustrant un dispositif codeur à turbo-code de type PCCC à deux dimensions ;
la Fig. 2 est un schéma illustrant un dispositif décodeur en mode série associé au dispositif codeur de la Fig. 1 ;
la Fig. 3 est un graphe montrant, en fonction du rapport signal sur bruit, la moyenne de la valeur absolue de l'information extrinsèque calculée en sortie d'un dernier décodeur d'une dernière itération, d'une part pour des séquences correctement décodées, et d'autre part pour des séquences présentant des erreurs résiduelles ;
la Fig. 4 est un organigramme illustrant un principe de base d'une procédure de décodage avec critère d'interruption selon un mode de réalisation de la présente invention.

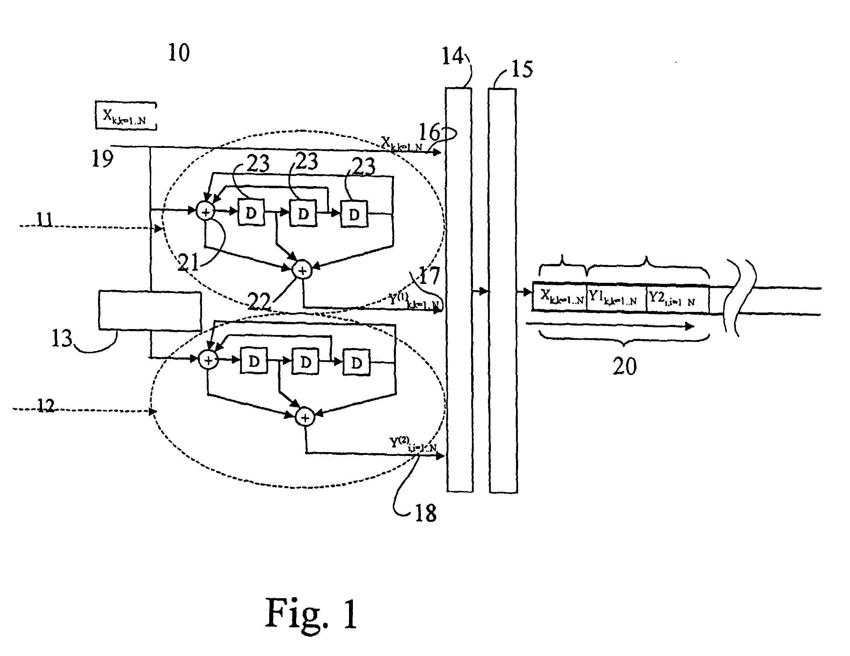

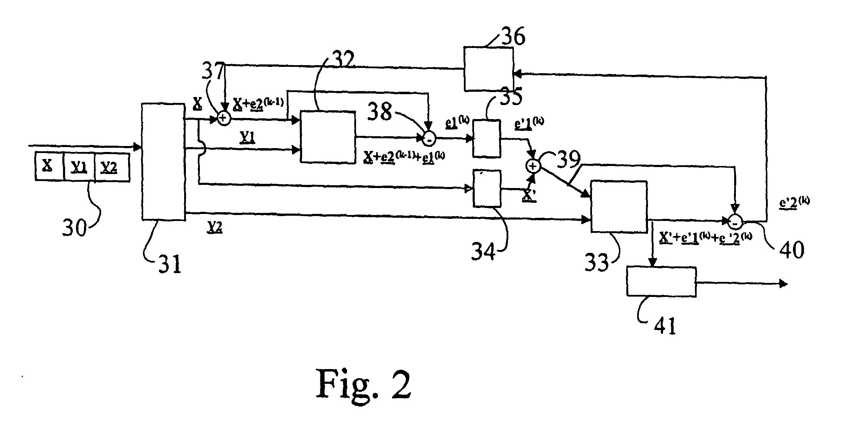

La présente invention sera illustrée notamment en référence à un procédé de transmission de type à codage correcteur d'erreurs utilisant un turbo-code de type PCCC à deux dimensions, un dispositif de turbo-codage appliquant ce procédé étant représenté de manière schématique sur la Fig. 1, et un dispositif de turbo-décodage appliquant ce procédé étant représenté sur la Fig. 2. On pourra facilement généraliser l'invention à des turbo-codes de plus grande dimension, utilisant d'autres types de codes élémentaires, et/ou à schémas de concaténation différents, notamment à des schémas de concaténation série, ainsi qu'à des schémas de concaténation de turbo-décodage différents.

Globalement, un procédé de transmission numérique de type à codage correcteur d'erreurs par turbo-code PCCC comprend une procédure de codage avant une étape de transmission et une procédure de décodage après une étape de transmission.

La procédure de codage est illustrée à travers le dispositif de codage représenté schématiquement sur la Fig. 1.

Globalement, ce dispositif de codage 10 comprend deux codeurs élémentaires 11 et 12 entre lesquels intervient un entrelaceur de taille N 13.

Chacun des codeurs élémentaires 11 et 12 est un codeur utilisant un code Convolutif Récursif Systématique (RSC). Ainsi qu'il est bien connu, chacun de ces codeurs élémentaires utilise une série d'informations auxiliaires, mémorisées dans un dispositif de type registre à décalage obtenues chacune par combinaison mathématique d'une information utile et d'informations auxiliaires calculées précédemment. Dans l'exemple présenté ici, le registre à décalage 23 emmagasine les données auxiliaires calculées par le OU exclusif 21 dont les entrées matérialisent le premier polynôme générateur du codeur RSC 11. Le produit de convolution est réalisé par le OU exclusif 22, les sorties du registre 23 matérialisant le deuxième polynôme générateur du codeur RSC 11. L'information utile est systématiquement transmise au côté d'une information de redondance qui apparaît en sortie de l'opérateur OU exclusif 22. L'étape d'entrelacement 13 de taille N modifie l'ordre de prise en compte des données par chacun des codes élémentaires. De la sorte, chacun des codeurs 11 et 12 génère une information redondante qui lui est associée. L'information utile n'est transmise qu'une fois. Ainsi, l'information codée telle qu'elle ressort de la procédure de codage est un bloc 20 comprenant l'information utile, ou partie systématique, et les deux informations redondantes, ou parties de l'information codée correspondant à chacun des codes élémentaires. Bien entendu, les deux codes élémentaires pourraient être différents. Après multiplexage 14, l'information codée peut être soumise à un poinçonnage 15. Le rendement de chacun des codeurs élémentaires est de ½ et, du fait que la partie systématique n'est transmise qu'une fois, le rendement R du turbo-code est de 1/3. Ce rendement peut bien entendu être augmenté par poinçonnage. Ainsi, le poinçonnage de la moitié des bits de redondance de chaque code élémentaire produirait un rendement R de ½.

L'information codée se présente sous forme de séquences de N blocs 20 composés de l'information systématique X et de la première et la seconde informations redondantes Y1 et Y2. Après poinçonnage éventuel, une séquence est transmise et subit les modifications apportées par le canal. Elle est ensuite reçue par le dispositif de décodage et éventuellement dépoinçonnée. Se présentent alors en entrée du démultiplexeur 31 N blocs 30 de longueur 3. Chacun de ces blocs 30 constitue une information reçue à décoder. Ils contiennent une partie d'information reçue correspondant à l'information utile, appelée information systématique X, une première partie d'information reçue correspondant à l'information redondante du premier code élémentaire, appelée première information redondante Y1, et une seconde partie d'information reçue correspondant à l'information redondante du second code élémentaire, appelée seconde information redondante Y2. La procédure de décodage fonctionne par séquences de décodage de N bits correspondant aux séquences de N blocs reçues.

Le dispositif de décodage, à concaténation en série, comprend un décodeur élémentaire 32 correspondant au premier codeur élémentaire 11 et un décodeur élémentaire 33 correspondant au second codeur élémentaire 12. Dans l'exemple considéré ici, les décodeurs élémentaires, utilisant un algorithme de type LogMAP, sont à entrées et sorties pondérées sous forme de logarithmes de rapports de vraisemblance (LRV). De ce fait, l'information extrinsèque est initialisée à 0 et la combinaison de l'information extrinsèque avec l'information systématique se fait par addition. Bien entendu, si les grandeurs manipulées par les décodeurs élémentaires sont autres, il faudra faire les changements correspondants. Par exemple, s'il s'agit de rapports de vraisemblance, l'information extrinsèque est initialisée à 1 et la combinaison se fait par produit. S'il s'agit de probabilités, l'information extrinsèque est initialisée à 0,5 et la combinaison se fait également par produit.

D'une part, la partie d'information reçue X correspondant à l'information utile est transmise aux décodeurs élémentaires 32 et 33. En direction du décodeur élémentaire 32, un additionneur 37 ajoute à cette information systématique X une information extrinsèque e2_{k'-1}. En direction du décodeur élémentaire 33, un additionneur 39 ajoute à cette information systématique X, entrelacée par un entrelaceur 34 de taille N correspondant à l'entrelaceur 13, une information extrinsèque e1_{k'}, entrelacée par un entrelaceur 35 de taille N correspondant à l'entrelaceur 13. D'autre part, la partie d'information reçue Y1 correspondant à l'information redondante du premier code élémentaire est transmise au décodeur 32 et la partie d'information reçue Y2 correspondant à l'information redondante du second code élémentaire est transmise au décodeur 33.

L'indice k' représente l'itération en cours de la procédure de décodage, l'information extrinsèque e2_{k'-1} étant donc calculée lors d'une itération précédant celle pendant laquelle est calculée l'information extrinsèque e1_{k'}.

L'information extrinsèque e1ₖ, est obtenue en sortie du décodeur élémentaire 32 lors d'une itération k', avec soustraction, au niveau d'un soustracteur 38, de l'information systématique X et de l'information extrinsèque e2_{k'-1}.

L'information extrinsèque e2_{k'} est obtenue, sous forme entrelacée e'2_{k'}, en sortie du décodeur élémentaire 33 lors d'une itération k', avec soustraction, au niveau d'un soustracteur 40, de l'information systématique entrelacée X' et de l'information extrinsèque entrelacée e'1_{k'}. Elle est désentrelacée par un désentrelaceur 36 de taille N correspondant à l'entrelaceur 13 avant transmission à l'itération suivante.

A l'issue d'une procédure de décodage, une séquence de décodage en sortie du second décodeur élémentaire 33 est désentrelacée et analysée par un bloc de décision 41 pour former une séquence décodée.

Au départ, l'information extrinsèque e2₀ est initialisée à 0. Lors de la première itération, l'information systématique X forme l'information a priori d'entrée du premier décodeur élémentaire 32. Le premier décodage élémentaire, à partir de la première information redondante Y1, produit une information de sortie pondérée D1₁, correspondant à une première estimation de séquence de décodage, et s'écrivant sous forme d'une combinaison de l'information systématique et de l'information extrinsèque e1₁, cette dernière correspondant à une augmentation de la fiabilité associée au premier décodage élémentaire. On a D1₁= X + e1₁, l'information extrinsèque e1₁ s'écrivant comme la différence entre l'information de sortie pondérée du premier décodeur, ici le logarithme de rapport de vraisemblance en sortie, et l'information d'entrée pondérée du premier décodeur, ici le logarithme de rapport de vraisemblance en entrée. Cette information extrinsèque e1₁, entrelacée et ajoutée à l'information systématique entrelacée X', forme l'information a priori d'entrée du second décodeur élémentaire 33. Le second décodage élémentaire, à partir de la seconde information redondante Y2, produit une information de sortie pondérée D'2₁, qui correspond à une seconde estimation de séquence de décodage, et qui s'écrit sous forme d'une combinaison de l'information systématique entrelacée, de l'information extrinsèque entrelacée e'1₁ et de l'information extrinsèque entrelacée e'2₁, cette dernière correspondant à une augmentation de la fiabilité associée au second décodage élémentaire. On a D'2₁ = X'+e'1₁+e'2₁, l'information extrinsèque entrelacée e'2₁ s'écrivant comme la différence entre l'information de sortie pondérée du second décodeur, ici le logarithme de rapport de vraisemblance en sortie, et l'information d'entrée pondérée du second décodeur, ici le logarithme de rapport de vraisemblance en entrée. L'information extrinsèque entrelacée e'2₁ forme après désentrelacement l'information extrinsèque e2₁ qui, ajoutée à l'information systématique X, forme l'information a priori d'entrée du premier décodeur élémentaire 32 pour la seconde itération. Le décodage élémentaire, toujours à partir de la première information redondante Y1, produit alors une information de sortie pondérée D1₂, qui correspond à une nouvelle estimation de séquence de décodage de fiabilité accrue. Une nouvelle information extrinsèque associée au décodeur 32 e1₂, entrelacée et ajoutée à l'information systématique entrelacée X', forme l'information a priori d'entrée du second décodeur élémentaire 33. Le second décodage élémentaire, toujours à partir de la seconde information redondante Y2, produit une information de sortie pondérée D'2₂, qui correspond à encore une nouvelle estimation de séquence de décodage de fiabilité accrue. Une nouvelle information extrinsèque associée au décodeur 33 e2₂, ajoutée à l'information systématique X, forme l'information a priori d'entrée du premier décodeur élémentaire 32 pour la troisième itération. Le processus se poursuit ensuite de la même façon, l'information extrinsèque, au fur et à mesure des itérations, gagnant en fiabilité, c'est-à-dire en amplitude dans le présent cas où elle s'exprime en terme de logarithme de rapport de vraisemblance. A l'issue de la procédure de décodage, après un nombre d'itérations k dont la détermination sera expliquée par la suite, la séquence de décodage entrelacée composée des informations de sortie pondérée D'2ₖ en sortie du second décodeur élémentaire 33 est désentrelacée et seuillée pour produire la séquence décodée.

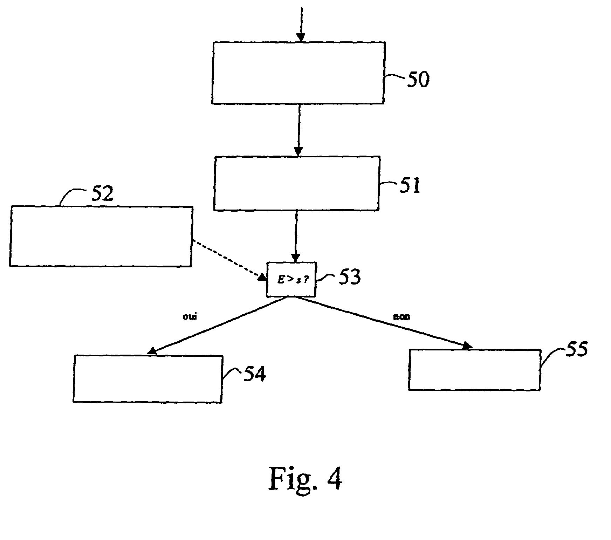

La Fig. 4 représente un mode de réalisation de la présente invention appliqué au cas d'un PCCC de dimension i tel le PCCC de dimension 2 qui vient d'être décrit.

Globalement, selon l'invention, une étape 51 de détermination de grandeur caractéristique et une étape 53 de comparaison, adaptée à comparer la grandeur caractéristique à une grandeur de seuil, sont associées à chacune des étapes de décodage élémentaire 50 d'une procédure de décodage itérative. La grandeur de seuil est déterminée par une étape de détermination de grandeur de seuil 52. Pendant l'étape de décodage élémentaire 50, l'étape de détermination de grandeur caractéristique est adaptée à calculer une grandeur caractéristique de la séquence de N informations extrinsèques en sortie de l'étape de décodage élémentaire 50. Une étape d'interruption 54 va interrompre la procédure de décodage si la grandeur caractéristique atteint et dépasse la grandeur de seuil. Sinon, à travers l'étape 55, la procédure de décodage va se poursuivre vers l'étape de décodage élémentaire suivante.

Plus précisément, l'étape de détermination de grandeur caractéristique 51 exécute un algorithme consistant, lors d'une i'^{ème} étape de décodage élémentaire d'une k'^{ème} itération, à calculer la moyenne E |ei'_{k'}| de la valeur absolue de l'information extrinsèque calculée sur la séquence de N valeurs extrinsèques en sortie du i'^{ème} décodeur lors de la k'^{ème} itération. Avantageusement, cette grandeur caractéristique est déterminée pour chaque étape de décodage élémentaire de manière à ce que le procédé de décodage itératif puisse être interrompu y compris au niveau d'une étape de décodage élémentaire se situant dans le corps d'une itération. Alternativement, cette grandeur caractéristique peut n'être calculée que pour certaines étapes de décodage élémentaire, par exemple pour la dernière étape de décodage élémentaire de chaque itération.

Ainsi, dans le cas du PCCC de dimension 2 décrit, cette étape 51 de détermination de grandeur caractéristique détermine, par exemple, lors du décodage élémentaire effectué par le second décodeur 33 lors d'une k'^{ème} itération, la moyenne E |e2_{k'}| de la valeur absolue de l'information extrinsèque calculée sur la séquence de N valeurs extrinsèques en sortie du second décodeur 33 lors de cette k'^{ème} itération.

Une fois la grandeur caractéristique E|ei'_{k'}| déterminée, à l'issue de la i'^{ème} étape de décodage élémentaire de la k'^{ème} itération, l'étape 53 de comparaison reçoit, d'une part, cette grandeur caractéristique E |ei'_{k'}| et, d'autre part, une grandeur de seuil s déterminée par l'étape de détermination de grandeur de seuil 52. Si l'étape 53 détermine que E |ei'_{k'}| >s, l'étape 54 est exécutée et la procédure de décodage itératif est interrompue au niveau de l'étape de décodage élémentaire i' de l'itération k'. Dans ce cas, la séquence de N informations de sortie pondérée associée à la séquence de N informations décodées par la procédure de décodage est la séquence de N informations de sortie pondérée générée par le i'^{ème} décodeur élémentaire lors de la k'^{ème} itération. Si l'étape 53 détermine que E |ei'_{k'}| n'est pas supérieure à s, l'étape 55 est exécutée et la procédure de décodage itératif se poursuit, le test d'interruption étant alors appliqué à l'issue de l'étape de décodage élémentaire suivante, et ainsi de suite.

L'étape de détermination de grandeur de seuil 52 détermine une grandeur de seuil s en fonction de paramètres de configuration. Il peut s'agir de paramètres caractérisant les conditions de transmission comme, par exemple, le rapport signal sur bruit. Il peut également s'agir de paramètres caractérisant, par exemple, la taille du bloc d'information utile, un algorithme de décodage élémentaire, un type de grandeurs utilisées, un nombre maximal d'itérations, un type de canal de transmission, etc. Ces paramètres de configuration caractérisent l'opération de décodage en cours.

Le choix de la grandeur de seuil va également dépendre de l'application dans le cadre de laquelle le procédé de transmission numérique intervient. Ainsi, la valeur de seuil devra souvent être choisie de manière à réaliser un compromis entre la performance permise par la procédure de décodage et la complexité de cette procédure de décodage. De la même manière, il pourra être choisi en fonction d'un délai moyen de transmission souhaité ou en fonction d'une consommation d'énergie moyenne tolérée.

Dans le présent exemple de réalisation, un nombre maximal d'itérations tolérable ayant été prédéfini, le seuil s est fixé en combinant deux grandeurs calculées de la même manière qu'est calculée la grandeur caractéristique selon la présente invention, soit, dans le cas présent, en faisant la moyenne des amplitudes de N informations extrinsèques d'une séquence de décodage. Ces deux grandeurs sont propres à une configuration donnée telle que définie par les paramètres de configuration et correspondant à l'opération de décodage en cours. Les première et seconde grandeurs caractérisent, dans cette configuration donnée, un ensemble d'informations extrinsèques généré par un dernier décodeur élémentaire, à l'issue de la procédure de décodage ayant exécuté le nombre maximal d'itérations prédéfini, respectivement dans le cas d'un décodage sans erreur et dans le cas d'un décodage pour lequel il reste des erreurs.

Avantageusement, cette première et cette seconde grandeur sont obtenues en fonction des paramètres de configuration à l'aide d'un algorithme adaptatif ou d'une table de référence préétablie, se basant sur une étude préalable de l'évolution de la grandeur caractéristique selon l'invention, ici la moyenne des amplitudes de N informations extrinsèques d'une séquence de décodage, en fonction des paramètres de configuration.

A titre d'exemple, la Fig. 3 montre sous forme de graphe un résultat d'une telle étude pour le PCCC du présent mode de réalisation. Les deux courbes 61 et 60 donnent la moyenne E|e2₂₀| de la valeur absolue de l'information extrinsèque en sortie du 2^{ème} décodeur de la 20^{ème} itération en fonction du rapport signal sur bruit Eb/No, respectivement dans le cas de séquences mal décodées, c'est-à-dire qui contiennent encore des erreurs, et dans le cas de séquences correctement décodées, c'est-à-dire ne contenant aucune erreur résiduelle. Les valeurs E|e2₂₀| ont été calculées, dans les deux cas et pour chaque valeur de rapport signal sur bruit, pour suffisamment de séquences pour obtenir des courbes exploitables. Dans le présent exemple, la longueur de la séquence de décodage (correspondant à la taille des entrelaceurs) est de N=640. Le signal en sortie du turbo-codeur est modulé par une modulation BPSK et transmis sur un canal à Bruit Blanc Additif Gaussien (BBAG).

Les courbes obtenues, exploitées par exemple au moyen d'une table de référence, permettent, pour un rapport signal sur bruit donné, formant paramètre de configuration, de déduire les première et seconde grandeurs dont la combinaison permet d'obtenir la grandeur de seuil s.

Par exemple, pour un rapport signal sur bruit de 0,78 dB et un nombre maximum d'itérations fixé à 20, la première grandeur, caractérisant un décodage sans erreur, est égale à 37,5 (point 63) et la seconde grandeur, caractérisant un décodage avec erreurs résiduelles, est égale à 3 (point 62).

Bien entendu, l'étape de détermination de grandeur de seuil pourra se fonder sur une pluralité de courbes caractéristiques, telles celles représentées sur la Fig. 3, correspondant à une pluralité de paramètres de configuration.

Afin de pouvoir adapter la grandeur de seuil en vue, par exemple, de réaliser un compromis entre la performance permise par la procédure de décodage et la complexité de cette procédure de décodage, ou en fonction, par exemple, d'un délai moyen de transmission souhaité ou d'une consommation d'énergie moyenne tolérée, la détermination de la grandeur de seuil par combinaison d'une première grandeur, caractérisant un décodage sans erreur, et d'une seconde grandeur, caractérisant un décodage avec erreurs résiduelles, se fait par l'intermédiaire d'un coefficient α permettant de privilégier l'une ou l'autre de ces grandeurs.

Dans le présent exemple de réalisation, la grandeur de seuil est la somme de la première grandeur multipliée par un coefficient α et de la seconde grandeur multipliée par un coefficient (1-α), le coefficient α étant choisi entre 0 et 1.

Le coefficient α est déterminé, par exemple à l'aide d'un algorithme adaptatif ou d'une table de référence, en fonction de l'application dans le cadre de laquelle le procédé de transmission numérique intervient. Plus α est petit, plus la complexité moyenne du décodage, le délai moyen de décodage et la consommation moyenne d'énergie pour le décodage d'une séquence sont réduits. Plus α est important, plus les performances permises par le décodage sont améliorées. Ainsi, par exemple, pour des applications pouvant tolérer des taux d'erreurs binaires ou paquet relativement élevés mais réclamant des délais faibles, comme c'est le cas pour des services voix, le paramètre α est choisi plutôt petit. Pour de telles applications, le nombre maximal d'itérations est également petit. En revanche, pour des applications nécessitant des taux d'erreurs binaires ou paquets faibles mais tolérant des délais élevés, comme c'est le cas pour des services de transfert de données, le paramètre α et le nombre maximal d'itérations sont choisis plutôt grands.

Par exemple, dans l'exemple de la Fig. 3, pour un rapport signal sur bruit de 0,78 dB, un coefficient α égal à 0,35 donne une grandeur de seuil s égale à 15. Si une procédure de décodage itératif d'une séquence est interrompue lorsque la grandeur caractéristique calculée pour cette séquence atteint la grandeur de seuil s=15, les performances en termes de taux d'erreurs binaires ne sont pas ou très peu dégradées par rapport au cas où la procédure de décodage va jusqu'au bout de ses vingt itérations. Par contre, le nombre moyen d'itérations effectué est de 3,8 au lieu de 20, ce qui se traduit par un gain de complexité supérieur à 5.

La présente invention s'applique à tous types de procédé de transmission utilisant un codage correcteur d'erreurs de type turbo-codage, qu'il s'agisse d'un turbo-codage série ou parallèle, voire d'un turbo-code à schéma de concaténation hybride mêlant concaténation série et concaténation parallèle.

L'on va brièvement présenter un mode de réalisation de la présente invention appliqué à un turbo-code série.

Par exemple, dans un turbo-code à concaténation série, chaque codeur élémentaire génère une information codée élémentaire à partir de l'information codée élémentaire issue du codeur élémentaire précédent, les i codeurs élémentaires étant séparés par (i-1) entrelaceurs. Des étapes de poinçonnage peuvent être réparties dans la procédure de codage, la sortie d'un j^{ème} codeur pouvant être poinçonnée par un j^{ème} vecteur de poinçonnage, entrelacée par un j^{ème} entrelaceur avant codage par un (j+1)^{ème} codeur. La taille de chaque entrelaceur dépend de l'étape de codage précédente, et, en particulier, du rendement après poinçonnage du codeur élémentaire précédent.

Dans un exemple de turbo-décodage correspondant au turbo-codage à concaténation série qui vient d'être décrit, les décodeurs élémentaires étant associés dans l'ordre inverse des codeurs élémentaires, chaque étape de décodage élémentaire reçoit deux informations pondérées a priori, l'une, appelée première information d'entrée, correspondant à l'information de sortie du codeur élémentaire correspondant, et l'autre, appelée seconde information d'entrée, correspondant à l'information d'entrée du codeur élémentaire correspondant. Cette étape de décodage élémentaire produit deux informations pondérées a posteriori, l'une, appelée première information de sortie, correspondant à la sortie du codeur élémentaire correspondant, et qui devient donc, lors d'une itération suivante, après entrelacement et poinçonnage correspondant, entrée *a priori* d'un décodeur élémentaire précédent, et l'autre, appelée seconde information de sortie, correspondant à l'entrée du codeur élémentaire correspondant, et qui devient donc, dans la même itération, après désentrelacement et dépoinçonnage correspondant, entrée a priori d'un décodeur élémentaire suivant. La première information d'entrée correspond à l'information à décoder par l'étape de décodage élémentaire. La seconde information de sortie correspond à l'information décodée par l'étape de décodage élémentaire, et elle est constituée de la combinaison de la seconde information d'entrée et d'une information extrinsèque.

Selon la présente invention, l'étape de détermination de grandeur caractéristique calcule, lors d'une étape de décodage élémentaire, une grandeur caractéristique à partir d'un ensemble d'informations extrinsèques en sortie de cette étape de décodage élémentaire. Par exemple, si l'on se réfère à l'exemple de turbo-décodage précédemment décrit, le calcul de grandeur caractéristique se fait à partir d'un ensemble d'informations extrinsèques issu d'un ensemble de secondes informations de sortie.

## Revendications

1. Procédé de transmission numérique de type à codage correcteur d'erreurs, comprenant, avant une étape de transmission sur un canal, une procédure de codage pour générer, à partir d'une information utile, une information codée comprenant au moins une information redondante et, après ladite étape de transmission sur ledit canal, une procédure de décodage pour obtenir, à partir d'une information reçue à décoder, une estimation de ladite information utile avec correction des erreurs de transmission basée sur ladite au moins une information redondante, ladite procédure de codage comprenant une pluralité d'étapes de codage élémentaire associée à au moins une étape d'entrelacement et opérant en parallèle ou en série, ladite procédure de décodage étant itérative et comprenant, pour chaque itération, une pluralité d'étapes de décodage élémentaire associée à des étapes d'entrelacement et de désentrelacement, correspondant à ladite pluralité d'étapes de codage élémentaire associée à ladite au moins une étape d'entrelacement, chacune desdites étapes de décodage élémentaire (50) recevant un ensemble d'informations à décoder et générant un ensemble d'informations de sorties pondérées associé à un ensemble d'informations décodées, ledit procédé étant **caractérisé en ce qu'**il comprend une étape de détermination de grandeur caractéristique (51) adaptée à calculer, pour chacune desdites étapes de décodage élémentaire (50), une grandeur caractéristique d'un ensemble d'informations extrinsèques associé seulement audit ensemble d'informations de sorties pondérées en sortie de cette étape de décodage élémentaire, une étape de comparaison (53) adaptée à comparer ladite grandeur caractéristique a une grandeur de seuil, et une étape d'interruption (54) pour interrompre ladite procédure de décodage lorsque ladite grandeur caractéristique atteint ladite grandeur de seuil.

2. Procédé de transmission numérique de type à codage correcteur d'erreurs selon la revendication 1, **caractérisé en ce que** ladite grandeur caractéristique calculée par ladite étape de détermination de grandeur caractéristique (51) est une grandeur statistique caractéristique dudit ensemble d'informations extrinsèques.

3. Procédé de transmission numérique de type à codage correcteur d'erreurs selon la revendication 2, **caractérisé en ce que** ladite grandeur statistique caractéristique est la moyenne de la valeur absolue desdites informations extrinsèques.

4. Procédé de transmission numérique de type codage correcteur d'erreurs selon la revendication 2 ou 3, **caractérisé en ce que** ladite étape d'interruption (54) interrompt ladite procédure de décodage lorsque ladite grandeur caractéristique est supérieure à ladite grandeur de seuil.

5. Procédé de transmission numérique de type à codage correcteur d'erreurs selon l'une quelconque des revendications précédentes, **caractérisé en ce que** ledit procédé de transmission numérique comprend également une étape de détermination de grandeur de seuil (52) pour déterminer une grandeur de seuil en fonction d'au moins un paramètre de configuration.

6. Procédé de transmission numérique de type à codage correcteur d'erreurs selon la revendication 5, **caractérisé en ce que** des paramètres de configuration sont le rapport signal sur bruit, la taille du bloc d'information utile, l'algorithme de décodage élémentaire, le type de grandeurs utilisées, le nombre maximal d'itérations, et le type de canal de transmission.

7. Procédé de transmission numérique de type à codage correcteur d'erreurs selon la revendication 5 ou 6, **caractérisé en ce que** ladite étape de détermination de grandeur de seuil (52) utilise un algorithme adaptatif permettant le calcul de ladite grandeur de seuil en fonction d'un ou de plusieurs paramètres de configuration.

8. Procédé de transmission numérique de type à codage correcteur d'erreurs selon la revendication 5 ou 6, **caractérisé en ce que** ladite étape de détermination de grandeur de seuil (52) utilise une table de référence préétablie permettant de sélectionner ladite grandeur de seuil en fonction d'un ou de plusieurs paramètres de configuration.

9. Procédé de transmission numérique de type à codage correcteur d'erreurs selon l'une quelconque des revendications 5 à 8, **caractérisé en ce que** ladite étape de détermination de grandeur de seuil (52) détermine une grandeur de seuil de manière à réaliser un compromis entre la performance permise par ladite procédure de décodage et la complexité de cette procédure de décodage.

10. Procédé de transmission numérique de type à codage correcteur d'erreurs selon l'une quelconque des revendications 6 à 9, **caractérisé en ce que** ladite étape de détermination de grandeur de seuil (52) détermine une grandeur de seuil en fonction d'un délai moyen de transmission souhaité.

11. Procédé de transmission numérique de type à codage correcteur d'erreurs selon l'une quelconque des revendications 6 à 9, **caractérisé en ce que** ladite étape de détermination de grandeur de seuil (52) détermine une grandeur de seuil en fonction d'une consommation d'énergie moyenne tolérée.

12. Procédé de transmission numérique de type à codage correcteur d'erreurs selon l'une quelconque des revendications 5 à 11, **caractérisé en ce que**, un nombre maximal d'itérations tolérable ayant été prédéfini, ladite étape de détermination de grandeur de seuil (52) détermine une grandeur de seuil en combinant, d'une part, une première grandeur (63) caractéristique d'un premier ensemble d'informations extrinsèques associé à un premier ensemble d'informations de sorties pondérées généré par un dernier décodeur élémentaire lors d'une dernière itération, en absence d'erreur de décodage et, d'autre part, une seconde grandeur (62) caractéristique d'un second ensemble d'informations extrinsèques associé à un second ensemble d'informations de sorties pondérées généré par ledit dernier décodeur lors de ladite dernière itération, en présence d'erreurs de décodage.

13. Procédé de transmission numérique de type à codage correcteur d'erreurs selon la revendication 12, **caractérisé en ce que** lesdites première et seconde grandeurs (63, 62) sont des grandeurs statistiques caractéristiques, respectivement, dudit premier ensemble d'informations extrinsèques et dudit second ensemble d'informations extrinsèques.

14. Procédé de transmission numérique de type à codage correcteur d'erreurs selon la revendication 12, **caractérisé en ce que** lesdites première et seconde grandeurs (63, 62) sont les moyennes de la valeur absolue de l'information extrinsèque calculées sur, respectivement, ledit premier ensemble d'informations extrinsèques et ledit second ensemble d'informations extrinsèques.

15. Procédé de transmission numérique de type à codage correcteur d'erreurs selon l'une quelconque des revendications 12 à 14, **caractérisé en ce que** lesdites première et seconde grandeurs (63, 62) sont déterminées, en fonction d'au moins un paramètre de configuration, à l'aide d'un algorithme adaptatif.

16. Procédé de transmission numérique de type à codage correcteur d'erreurs selon l'une quelconque des revendications 12 à 14, **caractérisé en ce que** lesdites première et seconde grandeurs (63, 62) sont déterminées, en fonction d'au moins un paramètre de configuration, à l'aide d'un algorithme adaptatif

17. Procédé de transmission numérique de type à codage correcteur d'erreurs selon l'une quelconque des revendications 12 à 14, **caractérisé en ce que** lesdites première et seconde grandeurs (63, 62) sont déterminées, en fonction d'au moins un paramètre de configuration, à l'aide d'une table de référence préétablie.

18. Procédé de transmission numérique de type à codage correcteur d'erreurs selon l'une quelconque des revendications 12 à 16, **caractérisé en ce** ladite grandeur de seuil est la somme de ladite première grandeur (63) multipliée par un coefficient α et de ladite seconde grandeur (62) multipliée par un coefficient (1-α), le coefficient α étant choisi entre 0 et 1.

19. Procédé de transmission numérique de type à codage correcteur d'erreurs selon la revendication 18, **caractérisé en ce que** ledit coefficient α est choisi de manière à réaliser un compromis entre la performance permise par ladite procédure de décodage et la complexité de cette procédure de décodage.

20. Procédé de transmission numérique de type à codage correcteur d'erreurs selon la revendication 18, **caractérisé en ce que** ledit coefficient α est choisi en fonction d'un délai moyen de transmission souhaité.

21. Procédé de transmission numérique de type à codage correcteur d'erreurs selon la revendication 18, **caractérisé en ce que** ledit coefficient α est choisi en fonction d'une consommation d'énergie moyenne tolérée.

22. Procédé de transmission numérique de type à codage correcteur d'erreurs selon l'une quelconque des revendications 18 à 21, **caractérisé en ce que** ledit coefficient α est déterminé à l'aide d'un algorithme adaptatif.

23. Procédé de transmission numérique de type à codage correcteur d'erreurs selon l'une quelconque des revendications 18 à 21, **caractérisé en ce que** ledit coefficient α est déterminé à l'aide d'une table de référence préétablie.

24. Procédé de transmission numérique de type à codage correcteur d'erreurs selon l'une quelconque des revendications précédentes, **caractérisé en ce que** lesdites étapes de décodage élémentaire (50) sont à entrées et sorties pondérées, en termes de probabilités, de rapports de vraisemblance, ou de logarithmes de rapports de vraisemblance.

25. Procédé de transmission numérique de type à codage correcteur d'erreurs selon l'une quelconque des revendications précédentes, **caractérisé en ce que** ladite procédure de codage comprend au moins une étape de poinçonnage et ladite procédure de décodage comprend au moins une étape de dépoinçonnage correspondante.

## Patentansprüche

1. Digitales Übertragungsverfahren des Typs mit Fehlerkorrekturcodierung, das vor einem Übertragungsschritt auf einem Kanal eine Codierungsvorgehensweise umfasst, um ausgehend von einer Nutzinformation eine codierte Information zu erzeugen, die zumindest eine redundante Information enthält, und nach dem Übertragungsschritt auf dem Kanal eine Decodierungsvorgehensweise, um ausgehend von einer zu decodierenden empfangenen Information eine Schätzung der Nutzinformation mit Korrektur der Übertragungsfehler basierend auf der mindestens einen redundanten Information zu erzielen, wobei die Codierungsvorgehensweise eine Vielzahl von Elementarcodierungsschritten verbunden mit mindestens einem Verschachtelungsschritt umfasst und parallel oder seriell funktioniert, wobei die Decodierungsvorgehensweise iterativ ist und für jede Iteration eine Vielzahl von E-lementardecodierungsschritten umfasst, die mit Verschachtelungsschritten und Entschachtelungsschritten verbunden sind, die der Vielzahl von Elementarcodierungsschritten entspricht, die mit dem mindestens einen Verschachtelungsschritt verbunden sind, wobei jeder der Elementardecodierungsschritte (50) eine zu decodierende Einheit von Informationen empfängt und eine Einheit von Informationen mit gewichteten Ausgängen erzeugt, die mit einer Einheit von decodierten Informationen verbunden sind, wobei das Verfahren **dadurch gekennzeichnet ist, dass** es einen Schritt des Bestimmens der charakteristischen Größe (51) umfasst, die für jeden der Elementardecodierungsschritte (50) eine charakteristische Größe einer Einheit von extrinsischen Informationen, die nur mit der Einheit von Informationen mit gewichteten Ausgängen am Ausgang dieses Elementardecodierungsschritts zusammenhängen, berechnen kann, einen Schritt (53), der die charakteristische Größe mit einer Schwellengröße vergleichen kann, und einen Unterbrechungsschritt (54), um die Decodierungsvorgehensweise zu unterbrechen, wenn die charakteristische Größe die Schwellengröße erreicht.

2. Digitales Übertragungsverfahren des Typs mit Fehlerkorrekturcodierung nach Anspruch 1, **dadurch gekennzeichnet, dass** die charakteristische Größe, die von dem Schritt des Bestimmens der charakteristischen Größe (51) berechnet wird, eine statistische Größe ist, die für die Einheit extrinsischer Informationen charakteristisch ist.

3. Digitales Übertragungsverfahren des Typs mit Fehlerkorrekturcodierung nach Anspruch 2, **dadurch gekennzeichnet, dass** die charakteristische statistische Größe der Durchschnitt des Absolutwerts der extrinsischen Informationen ist.

4. Digitales Übertragungsverfahren des Typs mit Fehlerkorrekturcodierung nach Anspruch 2 oder 3, **dadurch gekennzeichnet, dass** der Unterbrechungsschritt (54) die Decodierungsvorgehensweise unterbricht, wenn die charakteristische Größe größer ist als die Schwellengröße.

5. Digitales Übertragungsverfahren des Typs mit Fehlerkorrekturcodierung nach einem der vorhergehenden Ansprüche, **dadurch gekennzeichnet, dass** das digitale Übertragungsverfahren auch einen Schritt des Bestimmens einer Schwellengröße (52) umfasst, um eine Schwellengröße in Abhängigkeit von mindestens einem Konfigurationsparameter festzulegen.

6. Digitales Übertragungsverfahren des Typs mit Fehlerkorrekturcodierung nach Anspruch 5, **dadurch gekennzeichnet, dass** Konfigurationsparameter das Rauschverhältnis, die Größe des Nutzinformationsblocks, der Elementardecodierungsalgorithmus, der Typ der verwendeten Größen, die maximale Anzahl von Iterationen und der Übertragungskanalstyp sind.

7. Digitales Übertragungsverfahren mit Fehlerkorrekturcodierung nach Anspruch 5 oder 6, **dadurch gekennzeichnet, dass** der Schritt des Bestimmens der Schwellengröße (52) einen anpassungsfähigen Algorithmus verwendet, der das Berechnen der Schwellengröße in Abhängigkeit von einem oder mehreren Konfigurationsparametern erlaubt.

8. Digitales Übertragungsverfahren des Typs mit Fehlerkorrekturcodierung nach Anspruch 5 oder 6, **dadurch gekennzeichnet, dass** der Schritt des Bestimmens der Schwellengröße (52) eine im Voraus erstellte Referenztabelle verwendet, die es erlaubt, die Schwellengröße in Abhängigkeit von einem oder mehreren Konfigurationsparametern auszuwählen.

9. Digitales Übertragungsverfahren des Typs mit Fehlerkorrekturcodierung nach einem der Ansprüche 5 bis 8, **dadurch gekennzeichnet, dass** der Schritt des Bestimmens der Schwellengröße (52) eine Schwellengröße so festlegt, dass ein Kompromiss zwischen der Leistung, die von der Decodierungsvorgehensweise erlaubt wird, und der Komplexität dieser Decodierungsvorgehensweise hergestellt wird.

10. Digitales Übertragungsverfahren des Typs mit Fehlerkorrekturcodierung nach einem der Ansprüche 6 bis 9, **dadurch gekennzeichnet, dass** der Schritt des Bestimmens der Schwellengröße (52) eine Schwellengröße in Abhängigkeit von einer gewünschten mittleren Übertragungsdauer festlegt.

11. Digitales Übertragungsverfahren des Typs mit Fehlerkorrekturcodierung nach einem der Ansprüche 6 bis 9, **dadurch gekennzeichnet, dass** der Schritt des Bestimmens der Schwellengröße (52) eine Schwellengröße in Abhängigkeit von einem tolerierten mittleren Energieverbrauch festlegt.

12. Digitales Übertragungsverfahren des Typs mit Fehlerkorrekturcodierung nach einem der Ansprüche 5 bis 11, **dadurch gekennzeichnet, dass** nach dem Festlegen einer maximalen tolerierbaren Anzahl von Iterationen der Schritt des Bestimmens der Schwellengröße (52) eine Schwellengröße festlegt, indem er einerseits eine erste Größe (63), die für eine erste Einheit extrinsischer Informationen charakteristisch ist, die mit einer ersten Einheit von Informationen mit gewichteten Ausgängen verbunden ist, die von einem letzten Elementardecodierer während einer letzten Iteration erzeugt wurde, bei Abwesenheit eines Decodierungsfehlers, und andererseits eine zweite Größe (62) die für eine zweite Einheit extrinsischer Informationen charakteristisch ist, die mit einer zweiten Einheit von Informationen mit gewichteten Ausgängen verbunden ist, die von dem letzten Decodierer bei der letzten Iteration erzeugt wird, in Gegenwart von Decodierungsfehlern, kombiniert.

13. Digitales Übertragungsverfahren des Typs mit Fehlerkorrekturcodierung nach Anspruch 12, **dadurch gekennzeichnet, dass** die erste und die zweite Größe (63, 62) charakteristische statistische Größen sind, und zwar jeweils der ersten Einheit extrinsischer Informationen und der zweiten Einheit extrinsischer Informationen.

14. Digitales Übertragungsverfahren des Typs mit Fehlerkorrekturcodierung nach Anspruch 12, **dadurch gekennzeichnet, dass** die erste und die zweite Größe (63, 62) die Durchschnitte des Absolutwerts der extrinsischen Information sind, die jeweils an der ersten Einheit extrinsischer Informationen und an der zweiten Einheit extrinsischer Informationen berechnet werden.

15. Digitales Übertragungsverfahren des Typs mit Fehlerkorrekturcodierung nach einem der Ansprüche 12 bis 14, **dadurch gekennzeichnet, dass** die erste und die zweite Größe (63, 62) in Abhängigkeit von zumindest einem Konfigurationsparameter mit Hilfe eines anpassungsfähigen bzw. adaptiven Algorithmus festgelegt werden.

16. Digitales Übertragungsverfahren des Typs mit Fehlerkorrekturcodierung nach einem der Ansprüche 12 bis 14, **dadurch gekennzeichnet, dass** die erste und die zweite Größe (63, 62) in Abhängigkeit von zumindest einem Konfigurationsparameter mit Hilfe eines anpassungsfähigen bzw. adaptiven Algorithmus festgelegt werden.

17. Digitales Übertragungsverfahren des Typs mit Fehlerkorrekturcodierung nach einem der Ansprüche 12 bis 14, **dadurch gekennzeichnet, dass** die erste und die zweite Größe (63, 62) in Abhängigkeit von zumindest einem Konfigurationsparameter mit Hilfe einer im Voraus festgelegten Referenztabelle festgelegt werden.

18. Digitales Übertragungsverfahren des Typs mit Fehlerkorrekturcodierung nach einem der Ansprüche 12 bis 16, **dadurch gekennzeichnet, dass** die Schwellengröße die Summe der ersten Größe (63) multipliziert mit einem Koeffizienten α und der zweiten Größe (62) multipliziert mit einem Koeffizienten (1-α) ist, wobei der Koeffizient α zwischen 0 und 1 ausgewählt wird.

19. Digitales Übertragungsverfahren des Typs mit Fehlerkorrekturcodierung nach Anspruch 18, **dadurch gekennzeichnet, dass** der Koeffizient α so ausgewählt wird, dass ein Kompromiss zwischen der Leistung, die von der Decodierungsvorgehensweise erlaubt wird, und der Komplexheit dieser Decodierungsvorgehensweise hergestellt wird.

20. Digitales Übertragungsverfahren des Typs mit Fehlerkorrekturcodierung nach Anspruch 18, **dadurch gekennzeichnet, dass** der Koeffizient α in Abhängigkeit von einer gewünschten mittleren Übertragungsdauer ausgewählt wird.

21. Digitales Übertragungsverfahren des Typs mit Fehlerkorrekturcodierung nach Anspruch 18, **dadurch gekennzeichnet, dass** der Koeffizient α in Abhängigkeit von einem tolerierten mittleren Energieverbrauch ausgewählt wird.

22. Digitales Übertragungsverfahren des Typs mit Fehlerkorrekturcodierung nach einem der Ansprüche 18 bis 21, **dadurch gekennzeichnet, dass** der Koeffizient α mit Hilfe eines anpassungsfähigen bzw. adaptiven Algorithmus festgelegt wird.

23. Digitales Übertragungsverfahren des Typs mit Fehlerkorrekturcodierung nach einem der Ansprüche 18 bis 21, **dadurch gekennzeichnet, dass** der Koeffizient α mit Hilfe einer im Voraus erstellten Referenztabelle festgelegt wird.

24. Digitales Übertragungsverfahren des Typs mit Fehlerkorrekturcodierung nach einem der vorhergehenden Ansprüche, **dadurch gekennzeichnet, dass** die Elementardecodierungsschritte (50) gewichtete Eingänge und Ausgänge haben, was die Wahrscheinlichkeiten, Plausibilitätsverhältnisse oder Logarithmen von Plausibilitätsverhältnissen betrifft.

25. Digitales Übertragungsverfahren des Typs mit Fehlerkorrekturcodierung nach einem der vorhergehenden Ansprüche, **dadurch gekennzeichnet, dass** die Codierungsvorgehensweise zumindest einen Lochungsschritt umfasst und die Decodierungsvorgehensweise zumindest einen entsprechenden Entlochungsschritt umfasst.

## Claims

1. A method of digital transmission of the error-correcting coding type, comprising, before a transmission stage on a channel, a coding procedure to generate, from a piece of useful data, a piece of coded data including at least one redundant piece of data and, after the said transmission stage on the said channel, a decoding procedure to obtain, from a piece of data received to be decoded, an estimation of the said useful data with correction of the transmission errors based on the said at least one piece of redundant data, the said coding procedure including a plurality of elementary coding stages associated with at least one interlacing stage and operating in parallel or serially, the said decoding procedure being iterative and including, for each iteration, a plurality of elementary decoding stages associated with interlacing and de-interiacing stages, corresponding to the said plurality of elementary coding stages associated with the said at least one interlacing stage, each of the said elementary decoding stages (50) receiving a set of data to be decoded and generating a set of weighted output data associated with a set of decoded data, the said method being **characterised in that** it includes a stage for determining the characteristic magnitude (51) adapted to calculate, for each of the said elementary decoding stages (50), a characteristic magnitude of a set of extrinsic data associated only with the said set of weighted output data output by this elementary decoding stage, a comparison stage (53) adapted to compare the said characteristic magnitude with a threshold magnitude, and an interrupt stage (54) in order to interrupt the said decoding procedure when the said characteristic magnitude reaches the said threshold magnitude.

2. A method of digital transmission of the error-correcting coding type according to claim 1, **characterised in that** the said characteristic magnitude, calculated by the said stage for determining the characteristic magnitude (51), is a statistical characteristic magnitude of the said set of extrinsic data.

3. A method of digital transmission of the error-correcting coding type according to claim 2, **characterised in that** the said statistical characteristic magnitude is the mean of the absolute value of the said extrinsic data.

4. A method of digital transmission of the error-correcting coding type according to claim 2 or 3, **characterised in that** the said interrupt stage (54) interrupts the said decoding procedure when the said characteristic magnitude is in excess of the said threshold magnitude.

5. A method of digital transmission of the error-correcting coding type according to any one of the preceding claims, **characterised in that** the said method of digital transmission also includes a stage for determining the threshold magnitude (52) in order to determine a threshold magnitude as a function of at least one configuration parameter.

6. A method of digital transmission of the error-correcting coding type according to claim 5, **characterised in that** the configuration parameters are the signal-to-noise ratio, the size of the block of useful data, the elementary decoding algorithm, the type of magnitudes used, the maximum number of iterations and the type of data communication channel.

7. A method of digital transmission of the error-correcting coding type according to claim 5 or 6, **characterised in that** the said stage for determining the threshold magnitude (52) uses an adaptive algorithm allowing the said threshold magnitude to be calculated as a function of one or several configuration parameters.

8. A method of digital transmission of the error-correcting coding type according to claim 5 or 6, **characterised in that** the said stage for determining the threshold magnitude (52) uses a pre-established reference table allowing the said threshold magnitude to be selected as a function of one or several configuration parameters.

9. A method of digital transmission of the error-correcting coding type according to any one of claims 5 to 8, **characterised in that** the said stage for determining the threshold magnitude (52) determines a threshold magnitude in such a manner so as to realise a compromise between the performance allowed by the said decoding procedure and the complexity of this decoding procedure.

10. A method of digital transmission of the error-correcting coding type according to any one of claims 6 to 9, **characterised in that** the said stage for determining the threshold magnitude (52) determines a threshold magnitude as a function of a desired mean transmission time.

11. A method of digital transmission of the error-correcting coding type according to any one of claims 6 to 9, **characterised in that** the said stage for determining the threshold magnitude (52) determines a threshold magnitude as a function of a permissible mean power consumption.

12. A method of digital transmission of the error-correcting coding type according to any one of claims 5 to 11, **characterised in that**, a permissible maximum number of iterations having been pre-defined, the said stage for determining the threshold magnitude (52) determines a threshold magnitude by combining, on the one hand, a first characteristic magnitude (63) of a first set of extrinsic data associated with a first set of weighted output data, generated by a last elementary decoder during a last iteration, with the absence of any decoding errors, and, on the other hand, a second characteristic magnitude (62) of a second set of extrinsic data associated with a second set of weighted output data generated by the said last decoder during the said last iteration, in the presence of decoding errors.

13. A method of digital transmission of the error-correcting coding type according to daim 12, **characterised in that** the said first and second magnitudes (63, 62) are characteristic statistical magnitudes, respectively, of the said first set of extrinsic data and of the second set of extrinsic data.

14. A method of digital transmission of the error-correcting coding type according to daim 12, **characterised in that** the said first and second magnitudes (63, 62) are means of the absolute value of the extrinsic data calculated from, respectively, the said first set of extrinsic data and the said second set of extrinsic data.

15. A method of digital transmission of the error-correcting coding type according to any one of claims 12 to 14, **characterised in that** the said first and second magnitudes (63, 62) are determined, as a function of at least one configuration parameter, using an adaptive algorithm.

16. A method of digital transmission of the error-correcting coding type according to any one of claims 12 to 14, **characterised in that** the said first and second magnitudes (63, 62) are determined, as a function of at least one configuration parameter, using an adaptive algorithm.

17. A method of digital transmission of the error-correcting coding type according to any one of claims 12 to 14, **characterised in that** the said first and second magnitudes (63, 62) are determined, as a function of at least one configuration parameter, using a pre-established reference table.

18. A method of digital transmission of the error-correcting coding type according to any one of claims 12 to 16, **characterised in that** the said threshold magnitude is the sum of the said first magnitude (63) multiplied by a coefficient α and of the said second magnitude (62) multiplied by a coefficient (1 -α), the coefficient α being selected between 0 and 1.

19. A method of digital transmission of the error-correcting coding type according to daim 18, **characterised in that** the said coefficient α is selected in such a manner so as to realise a compromise between the performance allowed by the said decoding procedure and the complexity of this decoding procedure.

20. A method of digital transmission of the error-correcting coding type according to daim 18, **characterised in that** the said coefficient α is selected as a function of a desired mean transmission time.

21. A method of digital transmission of the error- correcting coding type according to claim 18, **characterised in that** said coefficient α is selected as a function of a permissible mean power consumption.

22. A method of digital transmission of the error-correcting coding type according to any one of claims 18 to 21, **characterised in that** the said coefficient α is determined using an adaptive algorithm.

23. A method of digital transmission of the error-correcting coding type according to any one of claims 18 to 21, **characterised in that** the said coefficient α is determined using a pre-established reference table.

24. A method of digital transmission of the error-correcting coding type according to any one of the preceding claims, **characterised in that** the said elementary decoding stages (50) have weighted inputs and outputs, in terms of probability, plausibility ratios, or plausibility ratio logarithms.

25. A method of digital transmission of the error-correcting coding type according to any one of the preceding claims, **characterised in that** the said coding procedure includes at least one punching stage and the said decoding procedure includes at least one corresponding depunching stage.
